# EUROPEAN PATENT APPLICATION

(11) **EP 4 275 806 A1**
(43) Date of publication of application: **15.11.2023**
(21) Application number: 21926790.3
(22) Date of filing: 16.12.2021
(51) Int. Cl.: B21B 45/02, C21D 9/00, B21B 37/44

(54) **METHOD FOR PREDICTING SHAPE OF STEEL SHEET, SHAPE CONTROL METHOD, MANUFACTURING METHOD, METHOD FOR GENERATING SHAPE PREDICTION MODEL, AND MANUFACTURING EQUIPMENT**

(30) Priority: 18.02.2021 JP 2021024366
(71) Applicant: JFE Steel Corporation, Tokyo 100-0011 (JP)
(72) Inventor: NOJIMA, Yusuke, Tokyo 100-0011 (JP); UEOKA, Satoshi, Tokyo 100-0011 (JP); TAMURA, Yuta, Tokyo 100-0011 (JP); HIRANO, Takahiro, Tokyo 100-0011 (JP); MIURA, Ken, Tokyo 100-0011 (JP); KURIMOTO,Atsushi, Tokyo 100-0011 (JP)
(74) Representative: Hoffmann Eitle
(86) International application number: PCT/JP2021/046560
(87) International publication number: WO 2022/176366

(57) **Abstract**

A steel sheet shape prediction method according to the present invention is a steel sheet shape prediction method in a cooling facility for a steel sheet, the cooling facility including a water cooling device that cools a steel sheet by ejecting cooling water to a heated steel sheet, and a restraint device that restrains the steel sheet being cooled with at least a pair of restraint rolls, the method including: predicting shape information of a steel sheet after passing through the cooling facility by using a shape prediction model generated by machine learning using at least one operation parameter selected from each of an operation parameter of the water cooling device and an operation parameter of the restraint device as input data and shape information of the steel sheet after passing through the cooling facility as output data.

## Description

### Field

The present invention relates to a steel sheet shape prediction method, a shape control method, a manufacturing method, a shape prediction model generation method, and a manufacturing facility.

### Background

Mechanical properties required for a steel sheet, particularly strength and toughness, have become particularly severe in recent years. In manufacturing of a steel sheet, required characteristics are secured by, in addition to performing direct quenching of a high-temperature steel sheet after hot rolling, performing quenching in a heat treatment facility or stopping cooling at a predetermined temperature during direct quenching or quenching in the heat treatment facility. At that time, it is important to make the cooling rate and the cooling stop temperature uniform over the entire width and the entire length so that uniform characteristics can be secured over the entire width and the entire length of the steel sheet.

Here, quenching refers to a heat treatment method in which a steel sheet after hot rolling at a temperature equal to or higher than the Ac3 transformation point, which is the temperature of completion of austenite transformation, and a steel sheet cooled after hot rolling and then heated again to a temperature equal to or higher than the Ac3 transformation point in a heating furnace or the like are rapidly cooled to a temperature equal to or lower than the martensite transformation start temperature (Ms point) with a cooling facility. Quenching is widely used particularly as a method for manufacturing a high-strength steel sheet. In addition, quenching a steel sheet after hot rolling without cooling and reheating is particularly referred to as direct quenching. On the other hand, a steel sheet once cooled after hot rolling may be quenched using a heat treatment facility including a heating furnace and a cooling facility at a location different from the rolling line.

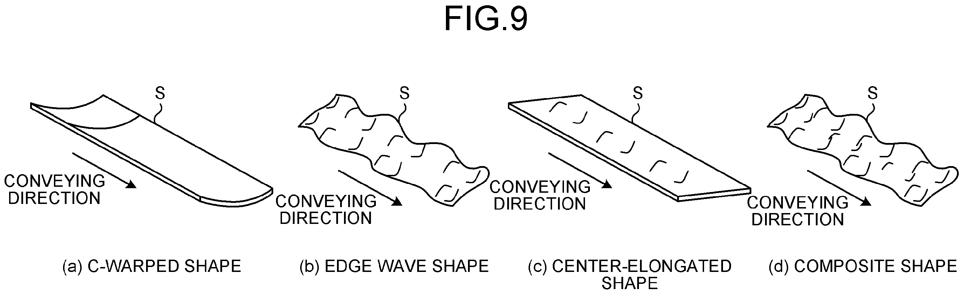

In recent years, for a steel sheet mainly used for transportation equipment, a steel sheet having a smaller sheet thickness than the conventional one is required for the purpose of reducing the weight of the equipment and reducing the energy consumption. However, as the sheet thickness is thinner, buckling is more likely to occur due to a non-uniform stress state in the plane, so that shape defects of the steel sheet are more likely to occur in a cooling process. Typical shape defect forms are illustrated in FIGS. 9(a) to 9(d). FIG. 9(a) illustrates a shape in which the heights of width-direction both end portions and a width-direction central portion of the steel sheet are different (referred to as a C-warped shape or a width-warped shape), FIG. 9(b) illustrates a shape in which a wave shape is observed at a width-direction end portion of the steel sheet (referred to as an edge wave shape or an end-elongated shape), FIG. 9(c) illustrates a shape in which a wave shape is observed at a width-direction central portion of the steel sheet (referred to as a center-elongated shape or a middle-elongated shape), and FIG. 9(d) illustrates a shape in which these shapes are combined (referred to as a composite shape).

A technique for predicting and controlling a shape defect occurring in a cooling process of such a steel sheet has been conventionally proposed. For example, Patent Literature 1 describes including a water cooling device for a steel sheet and a method of predicting a warped shape of a steel sheet during cooling or on a downstream side of a water cooling device on the basis of chemical components of the steel sheet and rolling conditions of a rolling process performed prior to water cooling of the steel sheet. The warped shape in this case is the C-warped shape illustrated in FIG. 9(a). On the other hand, Patent Literature 2 discloses a cooling method for suppressing a shape defect of a steel sheet in a steel sheet cooling facility including a water cooling device that ejects cooling water to the steel sheet and a restraint device that restrains the steel sheet being cooled with a plurality of roll pairs. In addition, Patent Literature 2 describes a method of predicting the wave shape of the steel sheet according to a speed at which the steel sheet passes through the cooling facility, a cooling rate of the steel sheet, a roll pitch of the restraint device, a sheet thickness and a sheet width of the steel sheet. The wave shape in this case is the edge wave shape illustrated in FIG. 9(b).

In addition, Patent Literature 3 describes a method for suppressing a shape defect of a steel sheet by adjusting at least one of a cooling water amount of a control cooling device and a bending amount of a hot leveler according to a predicted shape of the steel sheet after control cooling in a steel sheet manufacturing facility including the control cooling device as a water cooling device of the steel sheet and in which the hot leveler is disposed on an upstream side thereof. In addition, Patent Literature 3 describes that a shape defect of the steel sheet is predicted on the basis of a measured cooling stop temperature of the steel sheet, a width-direction temperature distribution, front and back surface temperatures during cooling, and a preset classification table. The shape defect in this case is the C-warped shape illustrated in FIG. 9(a), the edge wave shape illustrated in FIG. 9(b), and the center-elongated shape illustrated in FIG. 9(c), and it is determined which shape defect applies on the basis of the measured temperature information and the classification table.

### Citation List

### Patent Literature

Patent Literature 1: JP 2006-150411 A
Patent Literature 2: JP 2018-144050 A
Patent Literature 3: JP H10-5868 A

### Non Patent Literature

Non Patent Literature 1: Yoshizawa et al., "Automatic 3D Measurement of Shape by Grating Projection Method", Journal of the Japan Society of Precision Engineering, 53(3), 1987, 422-426

### Summary

### Technical Problem

However, the method described in Patent Literature 1 is directed to a facility including only a water cooling device as a steel sheet cooling facility, and is considered to be effective to some extent when there is no steel sheet restraint device, but there is room for improvement in predicting the shape of the steel sheet in the cooling facility including the restraint device. In addition, the shape defect to be predicted is a C-warped shape, and is not directed to a wave shape (edge wave shape or center-elongated shape) that is likely to occur in a steel sheet having a thin sheet thickness.

On the other hand, Patent Literature 2 describes a method of suppressing the edge wave shape of the steel sheet in the cooling facility including the water cooling device and the restraint device. In this method, the shape defect of the steel sheet can be improved to some extent by providing the restraint device, and the shape defect can be improved by passage through the cooling facility at a predetermined speed. However, the target shape defect is the edge wave shape, and it is not for suppressing the shape defect of the C-warped shape illustrated in FIG. 9(a) or the center-elongated shape illustrated in FIG. 9(c). Accordingly, there is room for improvement in suppressing the occurrence of the composite shape illustrated in FIG. 9 (d) .

In addition, the method described in Patent Literature 3 predicts the shape defect of the steel sheet on the basis of the steel sheet temperature information measured in the cooling facility and the preset classification table. However, the cause of the shape defect of the steel sheet generated in the cooling facility is not necessarily due to temperature nonuniformity. The shape defect of the steel sheet may occur due to a volume change due to heat shrinkage or phase transformation during cooling of the steel sheet. For this reason, even when the classification table is set on the basis of operating experience, it is not always possible to accurately predict the shape defect of the steel sheet that appears as various forms due to many causes.

The present invention has been made in view of the above problems, and an object thereof is to provide a steel sheet shape prediction method capable of accurately predicting shape information of the steel sheet after passing through a cooling facility. In addition, another object of the present invention is to provide a steel sheet shape control method capable of accurately controlling the shape of the steel sheet after passing through the cooling facility within an allowable range. In addition, another object of the present invention is to provide a steel sheet shape prediction model generation method for generating a shape prediction model capable of accurately predicting shape information of the steel sheet after passing through the cooling facility. In addition, another object of the present invention is to provide a steel sheet manufacturing method and a manufacturing facility capable of manufacturing a steel sheet having favorable flatness. Solution to Problem

To solve the problem and achieve the object, a steel sheet shape prediction method according to the present invention is the steel sheet shape prediction method in a cooling facility for a steel sheet, the cooling facility including a water cooling device that cools a steel sheet by ejecting cooling water to a heated steel sheet, and a restraint device that restrains the steel sheet being cooled with at least a pair of restraint rolls. The method includes: predicting shape information of the steel sheet after passing through the cooling facility by using a shape prediction model generated by machine learning using at least one operation parameter selected from each of an operation parameter of the water cooling device and an operation parameter of the restraint device as input data and shape information of the steel sheet after passing through the cooling facility as output data.

Moreover, in the steel sheet shape prediction method according to the present invention, the shape prediction model includes an attribute information parameter selected from attribute information of the steel sheet as the input data.

Moreover, in the steel sheet shape prediction method according to the present invention, the operation parameter of the water cooling device includes at least one of a cooling water amount, an upper-lower water amount ratio of cooling water, a cooling rate of the steel sheet, and a conveyance speed of the steel sheet in a cooling facility.

Moreover, in the steel sheet shape prediction method according to the present invention, the operation parameter of the restraint device includes at least one of a rolling position and a rolling force of the restraint roll.

Moreover, a steel sheet shape control method according to the present invention includes: predicting a shape of the steel sheet after passing through the cooling facility using the steel sheet shape prediction method according to the present invention; and resetting at least one operation parameter selected from the operation parameters of the water cooling device and the restraint device so that the predicted shape falls within a preset allowable range.

Moreover, a steel sheet manufacturing method according to the present invention includes: manufacturing a steel sheet using the steel sheet shape control method according to the present invention.

Moreover, a steel sheet manufacturing method according to the present invention includes: predicting a shape of a steel sheet after passing through the cooling facility using the steel sheet shape prediction method according to the present invention; and determining a treatment process of the steel sheet on a basis of the predicted shape.

Moreover, a steel sheet shape prediction model generation method according to the present invention is the steel sheet shape prediction model generation method in a cooling facility for a steel sheet, the cooling facility including a water cooling device that cools a steel sheet by ejecting cooling water to a heated steel sheet, and a restraint device that restrains the steel sheet being cooled with at least a pair of restraint rolls. The method includes: generating a shape prediction model of a steel sheet after passing through the cooling facility by machine learning using a plurality of pieces of training data in which information including at least one piece of operation record data selected from each of operation record data of the water cooling device and operation record data of the restraint device is used as input record data and shape information of the steel sheet after passing through the cooling facility corresponding to the input record data is used as output record data.

Moreover, in the steel sheet shape prediction model generation method according to the present invention, machine learning selected from a neural network, decision tree learning, random forest, and support vector regression is used as the machine learning.

Moreover, a steel sheet manufacturing facility according to the present invention includes: a cooling facility including a water cooling device that cools a steel sheet by ejecting cooling water to a heated steel sheet, and a restraint device that restrains the steel sheet being cooled with at least a pair of restraint rolls; and a shape prediction unit that outputs shape information of a steel sheet after passing through the cooling facility, wherein the shape prediction unit is a machine-learned model using at least one operation parameter selected from each of an operation parameter of the water cooling device and an operation parameter of the restraint device as input data and shape information of the steel sheet after passing through the cooling facility as output data.

### Advantageous Effects of Invention

According to the steel sheet shape prediction method according to the present invention, it is possible to accurately predict the shape information of the steel sheet after passing through the cooling facility. In addition, according to the steel sheet shape control method according to the present invention, it is possible to accurately control the shape of the steel sheet after passing through the cooling facility within the allowable range. In addition, according to the steel sheet shape prediction model generation method according to the present invention, it is possible to accurately predict the shape information of the steel sheet after passing through the cooling facility. In addition, according to the steel sheet manufacturing method and manufacturing facility according to the present invention, a steel sheet having favorable flatness can be manufactured.

### Brief Description of Drawings

FIG. 1 is a diagram illustrating a schematic configuration of a heat treatment facility including a steel sheet cooling facility according to one embodiment of the present invention.
FIG. 2 is a diagram illustrating a configuration of the cooling facility illustrated in FIG. 1.
FIG. 3 is a block diagram illustrating a configuration of a control computer illustrated in FIG. 1.
FIG. 4 is a block diagram illustrating a configuration of a shape prediction model generation unit according to one embodiment of the present invention.
FIG. 5 is a diagram for describing a configuration of a shape determination unit illustrated in FIG. 1.
FIG. 6 is a flowchart illustrating a flow of shape control processing according to one embodiment of the present invention.
FIG. 7 is a diagram in which pass/fail of a shape of a steel sheet obtained by preliminary confirmation is organized by conveyance speed and cooling water amount.
FIG. 8 is a diagram illustrating a configuration of a hot rolling line of an example.
FIG. 9 is a schematic diagram illustrating typical shape defect forms of a steel sheet.

### Description of Embodiments

Hereinafter, a steel sheet shape prediction method, a shape control method, a manufacturing method, a shape prediction model generation method, and a manufacturing facility according to one embodiment of the present invention will be described with reference to the drawings.

### [Cooling Facility]

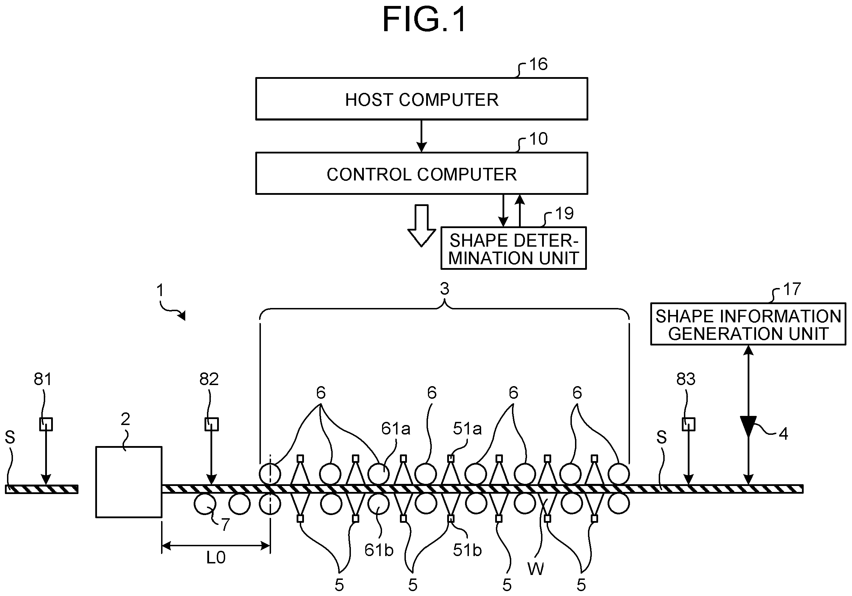

First, a configuration of a steel sheet cooling facility according to one embodiment of the present invention will be described with reference to FIG. 1.

FIG. 1 is a diagram illustrating a schematic configuration of a heat treatment facility including a steel sheet cooling facility according to one embodiment of the present invention. As illustrated in FIG. 1, a heat treatment facility 1 including a steel sheet cooling facility according to one embodiment of the present invention is an offline type heat treatment facility, and includes, as main components, a heating furnace 2 for heating a steel sheet S having a temperature of 100°C or lower to a predetermined temperature, a cooling facility 3 for cooling the steel sheet S heated in the heating furnace 2, a shapemeter 4 for measuring the shape of the steel sheet S on an exit side of the cooling facility 3, and a control computer 10 for controlling an operation of the heat treatment facility 1 including the cooling facility 3. The cooling facility 3 includes water cooling devices 5 that eject cooling water to the steel sheet S and restraint devices 6 that restrain the steel sheet S from above and below during cooling.

The heating furnace 2 is charged with the steel sheet S that has been hot-rolled to a predetermined thickness (for example, 30 mm) and width (for example, 2000 mm) by a hot rolling line at a location different from the heat treatment facility 1 and cooled to a temperature of about room temperature. The steel sheet S is heated to a predetermined temperature (for example, 910°C) in the heating furnace 2. The steel sheet S extracted from the heating furnace 2 is cooled in the cooling facility 3 while being conveyed by a plurality of table rolls 7 installed on the exit side of the heating furnace 2. In FIG. 1, the cooling facility 3 is drawn larger than the heating furnace 2 in order to describe the cooling facility 3 in detail. In practice, the length of the heating furnace 2 is about 60 to 80 m, and the facility length of the cooling facility 3 is about 20 to 25 m.

In general, in the offline type heat treatment facility, the steel sheet S is extracted from the heating furnace 2 and conveyed at a substantially constant speed until cooled by the cooling facility 3, so that the cooling start temperature difference between front and tail ends of the steel sheet S is small. That is, when the heating temperature of the steel sheet S is T0, the distance from the heating furnace 2 to the cooling facility 3 is L0, and the conveyance speed of the steel sheet S is V0, the front end portion of the steel sheet S is extracted at the temperature T0 and cooled through a radiational cooling time L0/V0. In the offline type heat treatment facility, since the distance L0 from the heating furnace 2 to the cooling facility 3 is short, the tail end portion of the steel sheet S is kept at the temperature T0 in the heating furnace 2 even when the front end portion of the steel sheet S is extracted from the heating furnace 2 and reaches the inlet of the cooling facility 3. Therefore, the tail end portion of the steel sheet S is also extracted at the temperature T0 in the same manner as the front end portion, and cooled through the radiational cooling time L0/V0, so that the cooling start temperature can be kept constant over the entire length of the steel sheet S. As described above, the offline type heat treatment facility is advantageous for manufacturing a steel sheet having a small in-plane temperature deviation with respect to a thin steel sheet whose temperature is easily lowered by radiational cooling, and, as a result, has a feature of easily controlling the flatness of the steel sheet S favorably. In addition, if necessary, the heat treatment facility 1 may be provided with a thermometer 81 for measuring the temperature of the steel sheet S on the inlet side of the heating furnace 2, a thermometer 82 for measuring the cooling start temperature, and a thermometer 83 for measuring the cooling end temperature. These temperature measurement results are sent to the control computer 10 as information for setting a heating condition and a cooling condition of the steel sheet S and specifying an operation record.

As described above, the present invention is mainly directed to a steel sheet cooling facility including a heating facility for heating the steel sheet S, a water cooling device for cooling the steel sheet S by ejecting cooling water to the steel sheet S heated by the heating facility, and a restraint device for restraining the steel sheet S during cooling with at least a pair of restraint rolls. However, the present invention can also be applied to an online type heat treatment facility. In this case, it is directed to a steel sheet cooling facility including a heating facility for heating the steel sheet S, a rolling mill that rolls the steel sheet S heated by the heating facility, a water cooling device for cooling the steel sheet S rolled to a predetermined sheet thickness by the rolling mill, and a restraint device for restraining the steel sheet S during cooling with at least a pair of restraint rolls. Also in this case, the steel sheet S is heated to a high temperature on the inlet side of the cooling facility, which is similar to the offline type cooling facility.

Unlike the offline type cooling facility, in the online type cooling facility, the heating furnace 2 is not disposed close to the cooling facility, and therefore, when the front end portion of the steel sheet S passes through the cooling facility 3, the stationary portion and the tail end portion of the steel sheet S are in a state of being cooled radiationally. Accordingly, the radiational cooling time until the start of cooling is longer at the tail end portion than at the front end portion of the steel sheet S, and when the length of the steel sheet S is L and the conveyance speed of the steel sheet S is V, there is a difference in radiational cooling time between the tail end portion and the front end portion by time L/V. Accordingly, even when the steel sheet temperature after rolling is uniform, the tail end portion is excessively cooled radiationally by the difference in radiational cooling time, so that a difference in cooling start temperature is generated between the front end portion and the tail end portion, and a temperature distribution is likely to occur in a longitudinal direction in the plane of the steel sheet S. For this reason, the online type heat treatment facility is more likely to have the condition that causes the shape defect of the steel sheet S. In this case, it is sufficient if the shape of the steel sheet S on the downstream side of the cooling facility is predicted at a plurality of locations along the longitudinal direction of the steel sheet S using a shape prediction model to be described below, and the operating condition in the cooling facility 3 is appropriately changed according to the shape that can change in the longitudinal direction of the steel sheet S.

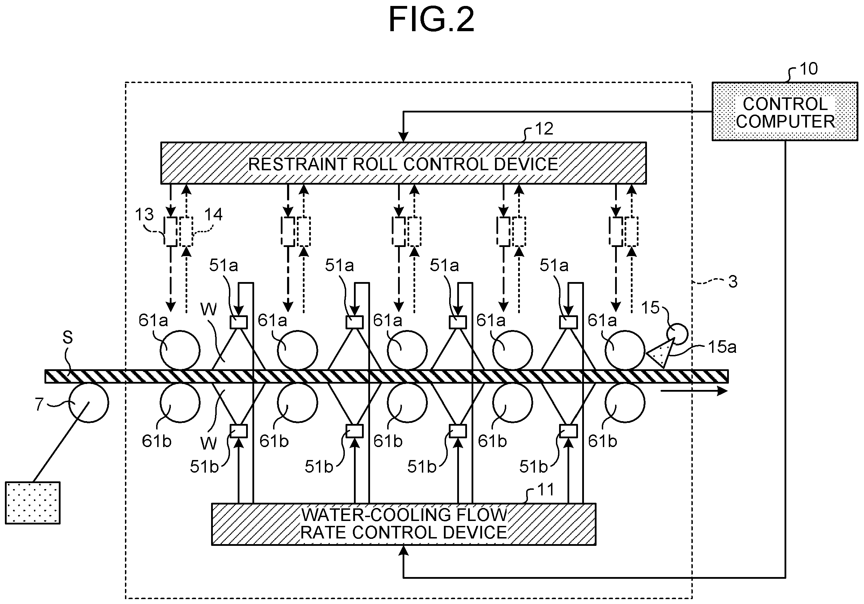

The cooling facility 3 is a facility including the water cooling devices 5 for water cooling of the steel sheet S under a predetermined cooling condition, and the restraint devices 6. These configurations will be described in detail with reference to FIG. 2. The water cooling devices 5 constituting the cooling facility 3 include a plurality of water cooling nozzles 51a and 51b disposed along the conveying direction of the steel sheet S so as to form a pair in an up-down direction of the steel sheet S. The water cooling nozzle 51a ejects cooling water W downward toward an upper surface of the steel sheet S. On the other hand, the water cooling nozzle 51b ejects the cooling water W upward toward a lower surface of the steel sheet S. The water cooling nozzles 51a and 51b constitute a pair of upper and lower water cooling nozzles, and a cooling section based on this is referred to as a cooling zone, and a set of one or a plurality of cooling zones is referred to as an area. In the example illustrated in FIG. 1, the cooling area (the area where water cooling is performed by the water cooling device 5) includes seven cooling zones, and in the example illustrated in FIG. 2, the cooling area includes four cooling zones. However, even when the number of cooling zones is other than the above, the effect of the present invention is not impaired. In addition, the cooling area may include a plurality of cooling zones, and cooling zones may be separated by an air cooling section in which the water cooling nozzle is not disposed.

As the water cooling nozzles 51a and 51b, those including a cooling flow rate adjusting valve and capable of adjusting the water amount of cooling water W ejected from each water cooling nozzle toward the steel sheet S are preferable. Thus, the flow rate of the cooling water ejected for each cooling zone can be adjusted. In addition, it is preferable that the water amounts of cooling water W ejected from the water cooling nozzle 51a and the water cooling nozzle 51b forming a pair in the up-down direction toward the steel sheet S can be adjusted to different values. The water amount of cooling water W ejected from each water cooling nozzle is controlled for each water cooling nozzle by a water-cooling flow rate control device 11 on the basis of the water amount setting value set by the control computer 10.

The operation parameter of the water cooling device 5 includes the water amount of cooling water W (cooling water amount) ejected from at least the pair of water cooling nozzles 51a and 51b and the speed of the steel sheet S conveyed by the table rolls 7 (conveyance speed). The larger the cooling water amount, the larger the cooling rate and the temperature decrease of the steel sheet S can be. On the other hand, the lower the conveyance speed of the steel sheet S, the larger the temperature decrease amount of the steel sheet S can be. In addition, by combining these operation parameters, the cooling stop temperature and the cooling rate are controlled as cooling conditions for obtaining a desired material.

In addition to these, the operation parameter of the water cooling devices 5 includes a balance (for example, the cooling water amount is increased in the cooling zone on the upstream side, and the cooling water amount is decreased in the cooling zone on the downstream side) of the cooling water amount for each cooling zone. The balance of the cooling water amount for each cooling zone can be expressed by the ratio of the cooling water amounts ejected in each cooling zone. This is because the cooling rate can be controlled according to the temperature range of the steel sheet S. Further, the number of cooling zones for ejection of the cooling water W may be changed. Different cooling stop temperatures can be controlled while setting the same cooling rate according to the number of cooling zones to be used. The cooling zone to be used may be specified using a sign or a numerical value for determining the use/non-use of each cooling zone, and these signs or numerical values may be used as the operation parameter of the water cooling devices 5.

Since the heat transfer coefficient of the cooling water W ejected from the water cooling nozzles 51a and 51b is higher as the water amount is larger, the material of the steel sheet S can be controlled by adjusting the cooling rate by adjusting the cooling water amount. As the water cooling nozzles 51a and 51b, a slit-type nozzle or a flat spray nozzle capable of uniformly ejecting a large flow rate of cooling water W in the width direction can be used. In addition, a multi-hole jet nozzle or a mist nozzle may be used.

As the water cooling nozzles 51a and 51b, those capable of adjusting the cooling water amount for each water cooling nozzle may not be necessarily used. This is because when the water cooling device includes a plurality of cooling zones, the cooling condition can be changed by changing the number of cooling zones for ejection of the cooling water W.

The cooling facility 3 includes the restraint devices 6 including at least a pair of restraint rolls that restrain the steel sheet S during cooling of the steel sheet S with the water cooling devices 5. The configuration of the restraint devices 6 will be described in detail with reference to FIG. 2.

The restraint devices 6 are disposed in the cooling area and are installed adjacent to the water cooling zone. Here, being adjacent means being disposed in a region where the steel sheet S is directly cooled by the cooling water W ejected from the water cooling nozzle 51a or the water cooling nozzle 51b or in a region where water spread of the cooling water W occurs on the upper surface of the steel sheet S. In the example illustrated in FIG. 2, restraint rolls 61a and 61b are disposed on the inlet side of the cooling facility 3. That is, the restraint rolls 61a and 61b are disposed at positions where the cooling water W ejected from the water cooling nozzle 51a in the cooling area on the most upstream is in contact with the restraint roll 61a as remaining water. In addition, also on the downstream side of each cooling zone, the restraint roll is disposed at a position where a part of the cooling water W ejected from the water cooling nozzle 51a or the water cooling nozzle 51b comes into contact.

The restraint roll 61a and the restraint roll 61b are disposed so as to be substantially perpendicular to the conveying direction of the steel sheet S so as to restrain the steel sheet S with the pair of upper and lower rolls. Strain due to heat shrinkage or phase transformation occurs in the steel sheet S during cooling by the water cooling devices 5, and the restraint rolls 61a and 61b are installed to restrain deformation of the steel sheet S so that the steel sheet S does not buckle due to such strain. Accordingly, it is preferable to dispose the restraint rolls at positions where strain is likely to occur in the steel sheet S, and this is the reason for disposing the restraint rolls adjacent to the water cooling zone. The reason for disposing the rolls facing each other in the up-down direction like roller levelers so as to apply the pressing force to the steel sheet S from the up-down direction instead of a staggered form is to apply a strong restraint to the steel sheet S by applying the pressing force to the steel sheet S when strain occurs in the steel sheet S.

In the example illustrated in FIG. 2, the restraint rolls 61a and 61b are installed corresponding to all the cooling zones, but in the cooling zone in which the cooling rate of the steel sheet S is low, strain due to heat shrinkage is small, and therefore, it is not always necessary to dispose the restraint rolls 61a and 61b in such a cooling zone. Note that, in the example illustrated in FIG. 2, five pairs of restraint rolls are disposed for four cooling zones, but it is not always necessary to dispose the restraint rolls on the most upstream side and the most downstream side of the cooling facility 3. However, as in the example illustrated in FIG. 2, by disposing the restraint rolls on the most upstream side of the cooling facility 3, it is possible to suppress the cooling water W ejected to the steel sheet S in the cooling zone from flowing out to the upstream side of the cooling facility 3, so that it is possible to have a function as drainage rolls in addition to the function of restraining the steel sheet S. The same applies to a case where the restraint rolls are disposed on the most downstream side of the cooling facility 3.

The restraint rolls 61a and 61b constituting the restraint device 6 include a mechanism capable of adjusting a gap between the upper and lower rolls. At that time, a mechanism can be provided in which the position of the lower restraint roll 61b in the up-down direction is fixed and the upper restraint roll 61a is raised and lowered. The lower restraint roll 61b may also have a function as the table roll 7.

In the example illustrated in FIG. 2, a restraint roll control device 12 sets the rolling position of each restraint roll on the basis of the restraint condition of the restraint devices 6 set by the control computer 10. The restraint roll control device 12 outputs a rolling position command to a rolling control device 13 that changes the position of the restraint roll using a power source such as hydraulic pressure, pneumatic pressure, or an electric motor. The rolling position of the restraint roll is measured by rolling position measuring instrument 14. The restraint roll control device 12 corrects the rolling position command to the rolling control device 13 on the basis of the measurement result of the rolling position, and controls the rolling positions of the restraint rolls 61a and 61b.

As a restraint condition of the steel sheet S by the restraint rolls 61a and 61b, a method of controlling the rolling force instead of the rolling positions of the restraint rolls 61a and 61b may be used. In this case, the setting value of the rolling force applied to the steel sheet S by the pair of upper and lower restraint rolls is sent from the control computer 10. A load detector using a load cell is installed in a support mechanism such as a housing that supports the restraint roll 61a on the upper surface side or the restraint roll 61b on the lower surface side, and the rolling position command is output to the rolling control device 13 so that the measured rolling force matches a target value. In this case, the load detector using a load cell plays a role instead of the rolling position measuring instrument 14 illustrated in FIG. 2.

The pressing force against the steel sheet S by the restraint rolls 61a and 61b is preferably 39 kN or more, more preferably 59 kN or more, and still more preferably 78 kN or more so that the steel sheet S does not buckle during cooling to increase the shape defect. However, when the pressing force is too large, the restraint rolls 61a and 61b are bent by elastic deformation, a gap is generated between the steel sheet S and the restraint rolls 61a and 61b, and there is a possibility that the shape of the steel sheet S is deteriorated. Therefore, the pressing force is preferably 196 kN or less. The appropriate condition range of the appropriate pressing force by the restraint rolls 61a and 61b varies depending on the heat treatment conditions such as the sheet thickness, the sheet width, the steel type, and the strength of the steel sheet S to be subjected to the heat treatment, the cooling water amount of the water cooling devices 5, the conveyance speed of the steel sheet S, the cooling stop temperature, and the cooling rate.

The mechanism that applies the pressing force using the restraint rolls 61a and 61b may be any of a spring type such as a spring or those capable of applying a constant pressing force such as pneumatic pressure or hydraulic pressure. For the purpose of adjusting the bending of the restraint rolls 61a and 61b, a mechanism capable of maintaining a constant pressing force is preferable, and further a mechanism having responsiveness capable of changing the pressing force in the longitudinal direction of the steel sheet S is preferable.

In the present embodiment, a drainage purge nozzle 15 is installed on the downstream side of the restraint roll 61a on the most downstream side of the cooling facility 3. The drainage purge nozzle 15 ejects drainage purge 15a at an angle in the direction of the restraint roll 61a so that the cooling water W leaking from the gap formed at the contact portion between the restraint roll 61a and the steel sheet S does not further flow downstream. The drainage purge 15a ejected to the upper surface of the steel sheet S is ejected at an angle also in the sheet width direction so as to discharge the cooling water W on the steel sheet S toward a sheet width end portion direction. The drainage purge 15a may be a liquid or a gas, and a mixed fluid thereof may be ejected. However, when water is used as the drainage purge 15a, there is a possibility that the temperature deviation of the steel sheet S is increased, and thus it is preferable to use gas. Further, it is more preferable to use air from the viewpoint of production cost. There is an effect of suppressing the expansion of the temperature deviation of the steel sheet S using the drainage purge 15a and suppressing the deterioration of the shape of the steel sheet S.

As the ejection amount and the ejection pressure of the drainage purge 15a are larger, the draining property is more favorable, but when the ejection pressure and the ejection amount of the drainage purge 15a are larger, the energy consumption of the pressure supply source for ejection increases. In addition, when air is used for the drainage purge 15a, there is a case where the cooling water W having passed through the restraint roll 61a splashes around by the air ejected toward the contact portion between the restraint roll 61a disposed on the most downstream side of the cooling facility 3 and the steel sheet S, and local temperature non-uniformity is generated in the steel sheet S. On the other hand, when water is used for the drainage purge 15a, the temperature deviation may occur on the surface of the steel sheet S. Accordingly, it is necessary to set an appropriate ejection pressure and ejection amount of the drainage purge 15a according to the amount of the cooling water W leaking to the downstream side of the restraint roll 61a.

Returning to FIG. 1. The control computer 10 acquires, from a host computer 16, information regarding the target range of the cooling stop temperature (target cooling stop temperature) and the target range of the cooling rate (target cooling rate) necessary for obtaining a desired material, in addition to information of the heating temperature, the sheet thickness, the sheet width, the weight, and the like of the steel sheet S. Then, the control computer 10 calculates the operating condition for achieving such a condition and determines an operation parameter of each equipment of the cooling facility 3.

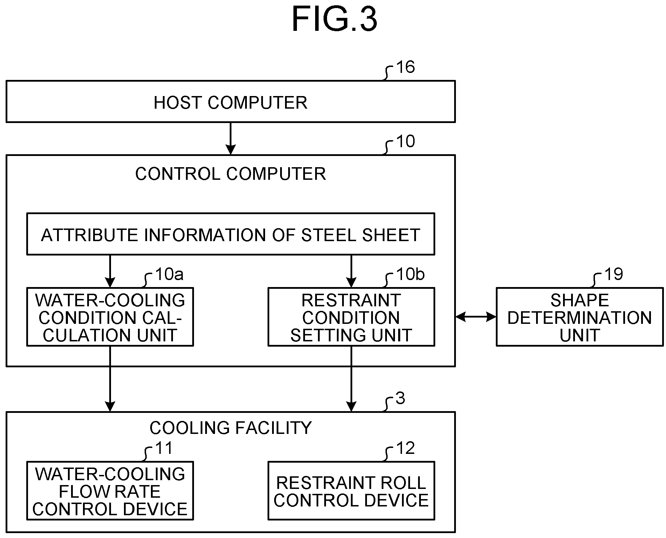

FIG. 3 is a block diagram illustrating a configuration of the control computer 10 of the present embodiment. As illustrated in FIG. 3, the control computer 10 acquires attribute information of the steel sheet S to be subjected to the heat treatment from the host computer 16. The attribute information of the steel sheet S includes, in addition to the information regarding dimensions of the steel sheet S such as the sheet thickness, the sheet width, and the sheet length (or weight) of the steel sheet S, information regarding a component composition of the steel sheet S (C content, Si content, Mn content, Cr content, Mo content, and the like of steel sheet S), and information regarding a target value of mechanical characteristics of the steel sheet S after heat treatment (yield stress, tensile strength, elongation, toughness, hardness, and the like).

In addition to the attribute information of the steel sheet S, the control computer 10 acquires the information regarding the target cooling stop temperature and the target cooling rate from the host computer 16. Then, the control computer 10 performs heat transfer calculation on the basis of an internal model with a water-cooling condition calculation unit 10a, and determines the operating condition of the water cooling devices 5 including the flow rate of the cooling water W of the water cooling nozzles 51a and 51b in the cooling area, the cooling zone in which the cooling water W is ejected, and the conveyance speed of the steel sheet S in the cooling facility 3 so as to satisfy the target cooling stop temperature and the target cooling rate set as the cooling condition.

The operating condition of the water cooling devices 5 set by the water-cooling condition calculation unit 10a is sent to the water-cooling flow rate control device 11. In the water-cooling flow rate control device 11, commands of the operating pressure and the number of operating cooling water pumps, the number of headers provided on the upstream side of the piping system of the water cooling nozzles 5a and 51b, the opening degree of a flow rate adjusting valve, and the rotation rate of a motor that drives the table rolls 7 are generated, and the operating condition of the water cooling devices 5 is set.

In addition, the control computer 10 includes a restraint condition setting unit 10b, and the restraint condition setting unit 10b sets the rolling position or the rolling force of the restraint rolls 61a and 61b according to the attribute information of the steel sheet. Normally, the setting values of the rolling position and the rolling force of each restraint roll are set as table values associated with the attribute information of the steel sheet S on the basis of the past operating experience.

The rolling position or the rolling force of the restraint roll set in the restraint condition setting unit 10b becomes an operating condition of the restraint devices 6 and becomes a control target value of the restraint roll control device 12. The restraint roll control device 12 outputs a control command to the power source of the rolling mechanism of the restraint rolls, and restrains the steel sheet S during water cooling with the restraint rolls on the basis of the measurement value of the rolling position or the rolling force.

Returning to FIG. 1. The shapemeter 4 is installed on the exit side of the cooling facility 3 and measures the shape of the steel sheet S cooled by the cooling facility 3. The shapemeter 4 is a device that measures the height distribution in the plane of the steel sheet S. Specifically, the shapemeter 4 measures the height distribution in the sheet width direction of the steel sheet S by scanning the steel sheet S with laser light in the sheet width direction, and measures the height distribution in the width direction for each position in the longitudinal direction in which the steel sheet S is conveyed on the table rolls 7. By repeating this from the front end portion to the tail end portion in the longitudinal direction of the steel sheet S, the in-plane height distribution of the steel sheet S can be acquired. When the shape of the steel sheet S is measured, the measurement pitch is preferably as fine as possible. This is because the measurement accuracy for various shapes illustrated in FIG. 9 is improved, and the form of the shape defect can be easily determined. Specifically, it is preferable that measurement can be performed at a pitch of 5 to 200 mm in the sheet width direction and the longitudinal direction, and a pitch of 5 to 100 mm is more preferable. In addition, the measurement pitch in the sheet width direction is more preferably 10 to 50 mm, and the measurement pitch in the longitudinal direction is more preferably 5 to 20 mm. Note that, for the shapemeter 4, a plurality of laser distance meters may be disposed in the sheet width direction of the steel sheet S, and the height distribution in the width direction may be measured with a plurality of distance meters. In this case, the laser distance meter is preferably disposed at a pitch of 40 to 200 mm in the sheet width direction of the steel sheet S.

The shapemeter 4 is not necessarily disposed on an extension line of the conveying direction of the steel sheet S in the cooling facility 3 as illustrated in FIG. 1. It may be installed such that the shape of the steel sheet S after passing through the cooling facility 3 can be measured offline, such as a cooling bed. On the other hand, as the shapemeter 4, the shape of the steel sheet S may be measured by the method described in Non Patent Literature 1 in which a specific optical pattern design is projected on the steel sheet S and the shape of the steel sheet S is estimated from the strain amount of the projected pattern.

Shape data of the steel sheet S measured by the shapemeter 4 is converted into shape information by a shape information generation unit 17. As the shape information, arbitrary information representing the shape data can be adopted. For example, the shape information can be defined by the difference between the maximum value and the minimum value of the height in the sheet width direction or the standard deviation of the height distribution at any position of the front end portion, the central portion, and the tail end portion in the longitudinal direction of the steel sheet S. In addition, in order to be able to consider a height change not only in the sheet width direction but also in the longitudinal direction, the difference between the maximum value and the minimum value of the height in the plane of the steel sheet S or the standard deviation of the height distribution, or a value obtained by averaging the differences between the maximum value and the minimum value of the height at each position in the longitudinal direction can be used. Further, a curve representing the relationship between the position and the height in the plane of the steel sheet extracted by an arbitrary filtering method such as a band-pass filter or a curve obtained by an arbitrary conversion method such as Gaussian curvature conversion may be used as the shape information. In addition, the curve obtained in this manner may be function-approximated, and a parameter that can specify the function obtained by the function approximation may be used as the shape information. Further, a two-dimensional image in which the height distribution in the plane of the steel sheet S is color-coded with contour lines may be used as the shape information.

The shape information regarding the C-warped shape illustrated in FIG. 9(a) can be specified by obtaining the difference between the maximum height and the minimum height in the width direction of the steel sheet S (C-warpage height) on the basis of the height information of the steel sheet S acquired by the shapemeter 4. In this case, the C-warpage height at a preset position in the longitudinal direction of the steel sheet S can be defined as the shape information regarding the C-warped shape of the steel sheet S. In addition, the maximum C-warpage height measured in the longitudinal direction of the steel sheet S may be used as the shape information regarding the C-warped shape of the steel sheet S.

For the edge wave shape illustrated in FIG. 9(b) and the center-elongated shape illustrated in FIG. 9(c), the length of a line segment along the steel sheet S along the longitudinal direction of the steel sheet S is calculated on the basis of the height information of the steel sheet S acquired by the shapemeter 4, and the material length at a specific position of the steel sheet S is calculated by integrating it in the longitudinal direction. Then, such calculation of the material length is performed for each position in the width direction of the steel sheet S. Thus, the material length in the longitudinal direction of the steel sheet S can be specified for each position in the width direction of the steel sheet S. The edge wave shape illustrated in FIG. 9(b) is a shape defect that occurs when the material length of the sheet width end portion is longer than the material length of the sheet width central portion of the steel sheet S, and the shape information of the edge wave shape can be set according to the ratio thereof. Such a material length ratio may be referred to as an elongation difference ratio. The center-elongated shape illustrated in FIG. 9(c) is a shape defect that occurs when the material length of the width-direction central portion is longer than the material length of the width-direction end portion of the steel sheet S, and the shape information of the center-elongated shape can be set according to the ratio thereof.

For the edge wave shape illustrated in FIG. 9(b), the pitch and the wave height of the unevenness may be calculated from the height distribution along the longitudinal direction of the width-direction end portion of the steel sheet S, and the edge wave shape may be specified by a value obtained by dividing the wave height of the wave shape by the pitch. The value calculated in this manner is called steepness, and can be used as shape information of the edge wave shape of the steel sheet S. The steepness of the edge wave shape is referred to as an edge wave steepness. Similarly, for the center-elongated shape illustrated in FIG. 9(c), the pitch and the wave height of the unevenness may be calculated from the height distribution along the longitudinal direction of the width-direction central portion the steel sheet S, and the steepness, which is a value obtained by dividing the wave height of the wave shape by the pitch, may be used as the shape information of the center-elongated shape of the steel sheet S. The steepness of the center-elongated shape is referred to as a center elongation steepness.

Since the composite shape illustrated in FIG. 9(d) is a shape defect in which the above-described shape defects are combined, the values of the C-warpage height, the edge wave steepness, and the center elongation steepness calculated by the above-described methods can be set as a set of datasets and used as the shape information of the steel sheet S. In addition, a diagram obtained by plotting the distribution of the material length in the longitudinal direction of the steel sheet S at each position with respect to the position in the width direction of the steel sheet S, or a curve obtained by function approximation of the distribution shape may be used as the shape information of the steel sheet S.

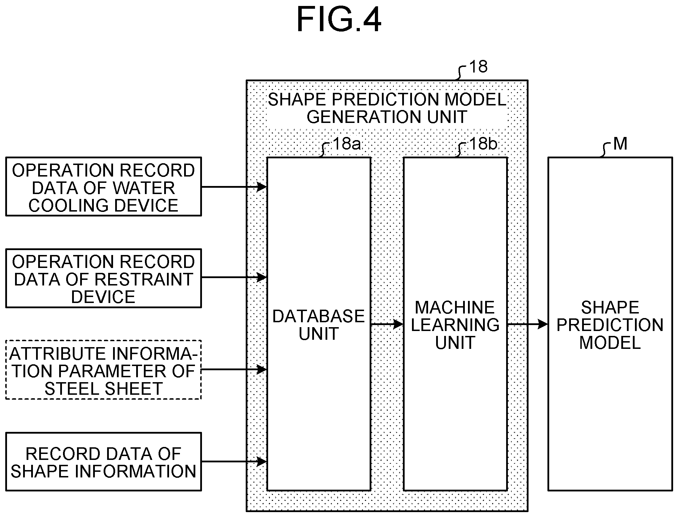

In the present embodiment, the above cooling facility 3 includes a shape prediction model generation unit 18 (see FIG. 4) that generates a shape prediction model of the steel sheet S after passing through the cooling facility 3 by machine learning using a plurality of pieces of training data in which information including at least one piece of operation record data selected from each of operation record data of the water cooling devices 5 and operation record data of the restraint devices 6 is used as input record data, and the shape information of the steel sheet S after passing through the cooling facility corresponding to the input record data is used as output record data.

FIG. 4 illustrates a configuration of the shape prediction model generation unit 18 according to one embodiment of the present invention. As illustrated in FIG. 4, the shape prediction model generation unit 18 according to one embodiment of the present invention includes a database unit 18a and a machine learning unit 18b. The database unit 18a acquires the operation record data of the water cooling devices 5 and the operation record data of the restraint devices 6, and acquires the shape information of the steel sheet S, which has been subjected to the heat treatment under the operating condition under which the operation record data has been acquired, and has passed through the cooling facility 3. The database unit 18a acquires parameters regarding the attribute information of the steel sheet S acquired from the host computer 16 or the control computer 10 as necessary. A plurality of types of data accumulated in the database unit 18a is associated on the basis of unique information that can specify the steel sheet S, such as the serial number of the steel sheet S to be subjected to the heat treatment.

The shape prediction model generation unit 18 may be provided inside the control computer 10 or may be configured by separate hardware capable of communicating with the control computer 10. In addition, it can be included in a shape determination unit 19, which will be described below.

As the operation record data of the water cooling devices 5, the cooling water amount by the water cooling devices 5 and the upper-lower water amount ratio of the cooling water W can be used. Regarding the cooling water amount, by assigning an identification number to each water cooling zone and upper and lower water cooling nozzles, the cooling water amount of each water cooling nozzle can be used as the operation record data of the water cooling devices 5. However, the sum of the cooling water amounts in the water cooling zones or the sum of the cooling water amounts in a plurality of water cooling zones arbitrarily selected from the water cooling zones may be used as the operation record data of the water cooling devices 5. In particular, in the plurality of cooling zones on the front stage side (upstream side) of the cooling area, since the temperature change of the steel sheet S is large and the effect on the shape of the steel sheet S is large, the sum of the cooling water amounts in two to three cooling zones on the front stage side of the cooling area may be used.

In a case where a flowmeter is installed in units of, for example, the water cooling zone, the water cooling nozzle, or a water cooling header on the upstream side of the piping system of the water cooling nozzle, the record data acquired by the flowmeter may be used as the operation record data of the water cooling devices 5. However, the setting value of the cooling water amount set in the water-cooling condition calculation unit 10a may be used. This is because when the setting value of the water cooling nozzle and the record value are compared in advance, it is considered that the actual cooling water amount does not greatly deviate from the setting value.

When the upper-lower water amount ratio of the cooling water W is used as the operation record data of the water cooling devices 5, the ratio of the flow rates ejected from the pair of upper and lower water cooling nozzles in the water cooling zone is used. This is because, when a temperature difference occurs between the upper and lower surfaces of the steel sheet S during cooling, depending on the upper-lower water amount ratio, the heat shrinkage amount is different between the upper and lower surfaces, which affects the shape of the steel sheet S.

Further, the cooling rate of the steel sheet S and the conveyance speed of the steel sheet S in the cooling facility 3 may be used as the operation record data of the water cooling devices 5. The cooling rate of the steel sheet S can be calculated from the difference between the cooling start temperature and the cooling end temperature, the distance between the thermometers, and the conveyance speed of the steel sheet S. This is because a temperature gradient generated in the longitudinal direction of the steel sheet S changes depending on the cooling rate of the steel sheet S, and the strain gradient in the longitudinal direction changes, which affects the shape of the steel sheet S. In addition, this is because the conveyance speed of the steel sheet S also affects the shape of the steel sheet S by changing the temperature gradient generated in the longitudinal direction of the steel sheet S.

In addition to the above, the operation record data of the water cooling devices 5 may include the cooling stop temperature of the steel sheet S. This is because, when the cooling stop temperature is low, the steel sheet S enters the cooling region of nucleate boiling, and the temperature deviation is likely to occur, and thus the shape of the steel sheet S may deteriorate.

As described above, the operation record data of the water cooling devices 5 preferably includes at least one of the cooling water amount, the upper-lower water amount ratio of the cooling water W, the cooling rate of the steel sheet S, and the conveyance speed of the steel sheet S in the cooling facility 3, and more preferably includes a plurality of pieces of operation record data from among these. This is because it is advantageous for predicting a complicated shape defect caused by a plurality of causes.

The operation record data of the restraint devices 6 preferably includes at least one of the rolling position and the rolling force of the restraint rolls. As the rolling position of the restraint rolls, a record value of the rolling position measured by the rolling position measuring instrument 14 can be used. However, a setting value set in the restraint roll control device 12 may be used. Similarly, when the rolling force of the restraint rolls is used, a record value of the rolling force measured by the load cell can be used. However, a setting value set by the restraint roll control device 12 may be used. Note that when a load detector using a load cell capable of measuring the rolling force of the restraint rolls is also disposed, both the rolling position and the rolling force can be used as the operation record data of the restraint devices 6. This is because the shape of the steel sheet S after cooling is affected depending on the magnitude of the restraint force with respect to the steel sheet S during cooling.

As the operation record data of the restraint devices 6, the operation data of any restraint rolls can be used as the operation record data of the restraint devices 6 by assigning an identification number to each pair of restraint rolls. However, the sum of the rolling forces of the plurality of pairs of restraint rolls may be used as the operation record data of the restraint devices 6. In particular, in the plurality of cooling zones on the front stage side (upstream side) of the cooling area, since the temperature change of the steel sheet S is large, the effect of the operating condition of the restraint rolls on the shape of the steel sheet S is large. For this reason, the sum of the rolling forces by two to three pairs of restraint rolls disposed on the front stage side of the cooling area may be used.

In a case where the rolling position is used as the operation record data of the restraint devices 6, the average position of the rolling positions of a plurality of arbitrarily selected restraint rolls can be used as the operation record data of the restraint devices 6. This is because the degree of restraining the steel sheet S changes according to the average value of the rolling positions by the plurality of restraint rolls.

As the operation record data of the restraint devices 6, in addition to the above, the difference between the rolling positions and the difference between the rolling forces at the positions of both ends at which the restraint rolls are supported may be used. This is because asymmetrical restraint in the width direction of the steel sheet S affects the shape. As the operation record data of the restraint devices 6, information for identifying which restraint rolls restrain the steel sheet S or whether the restraint rolls are released so as not to perform the restraint may be used. For example, reference numerals such as "1" may be assigned to the restraint rolls that restrain the steel sheet S and "0" may be assigned to the restraint rolls that are released, and a numerical string corresponding to the identification number of the restraint rolls may be used as the operation record data of the restraint devices 6.

As input data of a shape prediction model M, it is preferable to use a parameter regarding the attribute information of the steel sheet S in addition to the above. This is because the out-of-plane buckling of the steel sheet S is more likely to occur as the sheet thickness is thinner and the sheet width is wider, which affects the shape of the steel sheet after passing through the cooling device. In addition, the larger the sheet width, the larger the height of the sheet width end portion in the C-warped shape tends to be. Further, whether or not plastic deformation occurs due to buckling may be affected by mechanical properties such as yield stress of the steel sheet S, and therefore, it is preferable to use attribute information representing the mechanical properties of the steel sheet S as input data. Note that, since the component composition of the steel sheet S affects the phase transformation in the cooling process and the volume change due to the phase transformation affects the shape of the steel sheet S, it is preferable to use information regarding the component composition of the steel sheet S for the input data of the shape prediction model M with regard to a steel sheet in which the phase transformation occurs. The component composition of the steel sheet S may be indicated by weight% of the C content, the Si content, the Mn content, the Cr content, and the Mo content of the steel sheet, and can be used as a parameter regarding the attribute information of the steel sheet S.

The input data of the shape prediction model M is not limited to the above, but may include an operation parameter of the heating furnace 2 such as a record value or a setting value such as a temperature record or a retention time in each zone such as a heating zone or a soaking zone in the heating furnace 2 of the heat treatment facility 1. This is because the surface roughness of the steel sheet, the state of an oxide, and the like also affect the wettability of the cooling water W, and the temperature distribution in the plane of the steel sheet S during cooling changes, which indirectly affects the shape of the steel sheet S. In addition, when the drainage purge nozzle 15 is installed in the cooling facility 3, the ejection pressure and the ejection amount of the drainage purge 15a may be used as the input data of the shape prediction model M as the operation parameter of the drainage purge nozzle 15. This is because the ejection pressure and the ejection amount of the drainage purge 15a can affect the shape of the steel sheet S.

As described above, the operation record data of the water cooling devices 5, the operation record data of the restraint devices 6, the shape information of the steel sheet S after passing through the cooling facility 3, the attribute information of the steel sheet S acquired as necessary, the operation parameter of the heating furnace 2, and the operation record data of the operation parameter of the drainage purge nozzle 15 constitute a set of datasets for each steel sheet S, and are accumulated in a storage device of the database unit 18a.

In the database unit 18a, 20 or more datasets are accumulated for each classification of the same standard, steel type, and size. The number is preferably 100 or more, and more preferably 500 or more. In addition, when a steel sheet S having a different standard, steel type, or size is included, it is preferable to accumulate 2000 or more datasets including record data of information (attribute information parameter) regarding the attribute information of the steel sheet S.

When the operation record data of the water cooling devices 5 and the operation record data of the restraint devices 6 can be continuously acquired with respect to the longitudinal direction of the steel sheet S, the steel sheet S may be divided in the longitudinal direction, the operation record data may be acquired for each section, and the shape information calculated for each corresponding section may be associated. In this case, a plurality of datasets is generated for one steel sheet S and accumulated in the database unit 18a.

Screening may be performed as necessary on the data accumulated in the database unit 18a, and data indicating an anomalous value may be removed. This is because highly reliable data is accumulated, and the shape prediction accuracy is improved. For the datasets accumulated in the database unit 18a, a certain number of datasets may be set as an upper limit, and the datasets accumulated in the database unit 18a may be appropriately updated within the upper limit.

The machine learning unit 18b uses the datasets accumulated in the database unit 18a and generates the shape prediction model M of the steel sheet S after passing through the cooling facility 3 by machine learning using a plurality of pieces of training data in which information including at least one piece of operation record data selected from each of the operation record data of the water cooling devices 5 and the operation record data of the restraint devices 6 is used as input record data, and the shape information of the steel sheet S after passing through the cooling facility 3 corresponding to the input record data is used as output record data. In addition, machine learning may be performed by including the attribute information parameter of the steel sheet S, the operation record data of the heating furnace 2, and the operation record data of the drainage purge nozzle 15 accumulated in the database unit 18a in the above input record data as necessary.

A machine-learned model for generating the shape prediction model M may be any machine-learned model as long as practically sufficient shape prediction accuracy can be obtained. For example, it is sufficient if commonly used neural networks (including deep learning, convolutional neural networks, and the like), decision tree learning, random forest, support vector regression, and the like are used. In addition, an ensemble model obtained by combining a plurality of models may be used.

As the shape prediction model M, instead of a regression model that outputs the shape information of the steel sheet S by numerical values, a machine-learned model may be used in which it is determined whether or not the shape is within a predetermined allowable range of shape, and data obtained by binarizing the result into pass/fail is used as the output record data. At that time, a classification model such as k-nearest neighbor algorithm or logistic regression can be used.

The shape prediction model M may be updated to a new model by retraining, for example, every month or every year. This is because the more data stored in the database unit 18a, the more accurate the shape prediction becomes, and a shape prediction model M reflecting the change in the operating condition with time can be generated by updating the shape prediction model M on the basis of the latest data.

The shape prediction model M generated as described above includes at least one operation parameter selected from each of the operation parameter of the water cooling devices 5 and the operation parameter of the restraint devices 6 in the input data, and uses the shape information of the steel sheet after passing through the cooling facility 3 as output data.

The reason why the cooling facility 3 includes the restraint devices 6 in addition to the water cooling devices 5 will be described. First, when the restraint devices 6 are not provided, the shape defect observed on the downstream side of the cooling facility 3 often has the C-warped shape illustrated in FIG. 9(a). This is because the shape defect is mainly caused by the difference in the cooling state between the upper and lower surfaces of the steel sheet S, and the condition is provided under which the elongation difference ratio is hardly generated in the longitudinal direction at each position in the width direction of the steel sheet S. In this case, since the steel sheet S is not restrained during cooling, a very large warpage may occur as the C-warped shape.

On the other hand, when the restraint devices 6 are provided together with the water cooling devices 5, the steel sheet S being cooled is restrained from above and below by the restraint rolls, and the C-warped shape of the steel sheet S is suppressed, but the strain difference between the upper and lower surfaces of the steel sheet S may change to the elongation difference ratio in the longitudinal direction at each position in the width direction. That is, in a facility including the water cooling devices 5 and the restraint devices 6 as the cooling facility 3, a large C-warped shape is suppressed, but the edge wave shape illustrated in FIG. 9(b) or the center-elongated shape illustrated in FIG. 9(c) tends to easily occur. In this case, depending on the combination of the operating condition of the water cooling devices 5 and the operating condition of the restraint devices 6, the composite shape illustrated in FIG. 9(d) can also be obtained.

In an actual cooling facility, a shape defect occurs due to various factors in addition to the above. For example, the strain gradient in the longitudinal direction of the steel sheet S due to heat shrinkage changes depending on the operating condition of the water cooling devices 5. In addition, depending on the operating condition of the water cooling devices 5, a temperature difference may occur between the width-direction end portion and the width-direction central portion of the steel sheet S, and a temperature distribution may occur in the plane of the steel sheet S, and as a result, a strain distribution may occur in the plane. Further, in the temperature range from the transformation start temperature to the transformation end temperature of the steel sheet S, a local volume change due to phase transformation occurs, a strain distribution occurs in the plane of the steel sheet S, and the shape of the steel sheet S may deteriorate.

The shape defect of the steel sheet S generated at the time of water cooling as described above causes a large C warpage when the restraint devices 6 are not provided, whereas the displacement in the height direction of the steel sheet S is suppressed by adding the restraint devices 6 to the water cooling devices 5, but the shape of the steel sheet S changes complicatedly due to various factors. Accordingly, in order to predict the shape of the steel sheet S appearing in such various forms, it is necessary to consider both the operation parameter of the water cooling devices 5 and the operation parameter of the restraint devices 6.

For example, even when an appropriate condition is set as the operating condition of the water cooling devices 5 such that the C-warped shape is suppressed without using the restraint devices 6, when a high-load condition is set as the operating condition of the restraint devices 6 such that the restraint rolls bend, a distribution occurs in the gap between the steel sheet S and the restraint rolls. In this case, the remaining water on the upper surface of the steel sheet S becomes non-uniform in the width direction, and cooling unevenness occurs in the plane of the steel sheet S. Such cooling unevenness due to the remaining water on the steel sheet S causes a strain in the plane of the steel sheet S and causes a shape defect.

On the other hand, even when an appropriate condition is set as the operating condition of the restraint devices 6 such that the restraint rolls do not bend, when a water-cooling condition is set as the operating condition of the water cooling devices 5 such that a transition boiling region is locally formed in the plane of the steel sheet S, a shape defect due to the cooling strain occurs. In this case, the force acting on the restraint rolls from the steel sheet S is distributed, and as a result, the restraint rolls bend, and the shape of the steel sheet S may deteriorate.

Not only the above causes but also the behavior of phase transformation occurring during cooling of the steel sheet S affects the shape defect of the steel sheet S. For example, as the operation parameter of the restraint devices 6, there is a case where the rolling force of the restraint rolls located in the cooling zone having a temperature at which the phase transformation occurs during cooling of the steel sheet S is set to be larger than that in other cooling zones. This is to suppress the strain generated in the steel sheet S due to the volume change due to the phase transformation.

However, depending on the setting of the operation parameter of the water cooling devices 5, the phase transformation may occur at a position different from the cooling zone in which the phase transformation is predicted to occur. In this case, the rolling force of the restraint rolls located in the cooling zone where the phase transformation has actually occurred is set to be small, and the rolling force of the restraint rolls located in the cooling zone where the phase transformation is predicted to occur is set to be excessively large. Thus, the operation parameter of the restraint devices 6 becomes inappropriate, and a shape defect may occur. In addition, depending on the setting of the rolling position of the restraint rolls of the restraint devices 6, the flow situation of the cooling water discharged from the corresponding cooling zone to another cooling zone changes, so that the temperature history of the steel sheet S changes, and the cooling zone in which the phase transformation is started may change to a position different from the previously-assumed cooling zone.

As described above, in the facility that cools the steel sheet S using both the water cooling devices 5 and the restraint devices 6 as the cooling facility, the shape of the steel sheet is affected by the operation parameter of the water cooling devices 5 and the restraint devices 6. Furthermore, the operation parameter of the water cooling devices 5 and the operation parameter of the restraint devices 6 are mutually related particularly with respect to the C-warped shape caused by the draining property of the steel sheet S, the shape change caused by the volume change of the steel sheet S in the transformation temperature range, or the flow behavior of the cooling water W in the cooling zone. Accordingly, in the shape prediction of the steel sheet S, it is difficult to accurately predict the shape of the steel sheet S only with the operating condition of the water cooling devices 5 or only with the operating condition of the restraint devices 6, and the prediction accuracy of the shape prediction model M is improved by using both operating conditions as the input data.

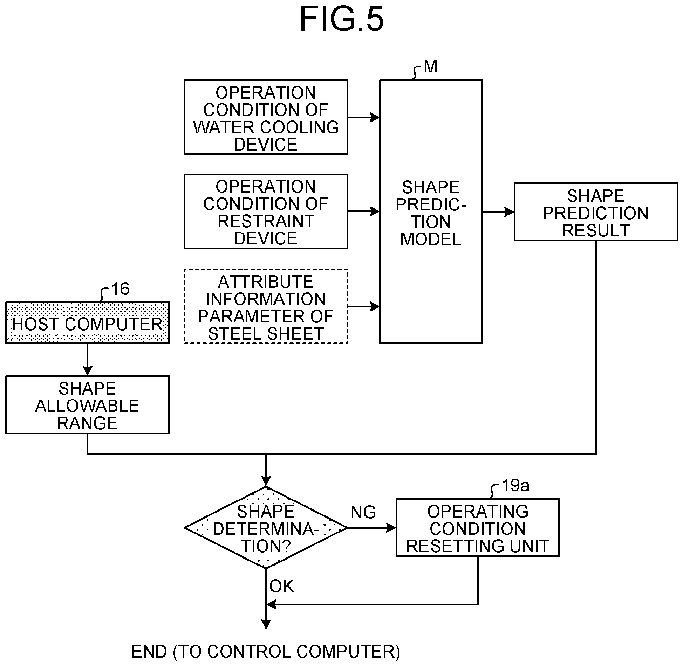

As illustrated in FIG. 1, a steel sheet shape control device according to the present embodiment includes the shape determination unit 19 associated with the control computer 10. FIG. 5 is a diagram for describing a configuration of the shape determination unit 19. The shape prediction model M used by the shape determination unit 19 is the shape prediction model M generated by the shape prediction model generation unit 18 described above. As illustrated in FIG. 5, in the present embodiment, the operating condition of the water cooling devices 5 and the operating condition of the restraint devices 6 set by the control computer 10, and as necessary the attribute information parameter of the steel sheet S are sent to the shape determination unit 19. The shape determination unit 19 predicts the shape of the steel sheet S on the exit side of the cooling facility 3, and resets at least one operation parameter selected from the operation parameters of the water cooling devices 5 and the restraint devices 6 with an operating condition resetting unit 19a so that the predicted shape falls within a preset allowable range (shape allowable range).

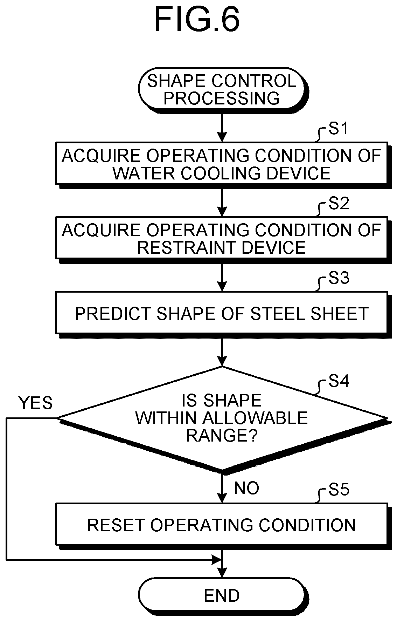

Hereinafter, the operation of the shape determination unit 19 when executing the shape control processing according to one embodiment of the present invention will be described with reference to FIG. 6.

FIG. 6 is a flowchart illustrating a flow of shape control processing according to one embodiment of the present invention. The flowchart illustrated in FIG. 6 starts at the timing when the information regarding the specifications and manufacturing conditions of the steel sheet S to be treated in the heat treatment facility 1 is input from the host computer 16 to the control computer 10, and the initial setting of the operating conditions of the water cooling devices 5 and the restraint devices 6 is performed by the water-cooling condition calculation unit 10a and the restraint condition setting unit 10b of the control computer 10, and the shape control processing proceeds to the processing of Step S1.

In the processing of Step S1, the water-cooling condition calculation unit 10a acquires the operating condition of the water cooling devices 5 such as cooling water amount and the conveyance speed of the table rolls set to satisfy the target cooling condition. Thus, the processing of Step S1 is completed, and the shape control processing proceeds to the processing of Step S2.

In the processing of Step S2, the restraint condition setting unit 10b acquires the initial condition of the rolling position and the rolling force of the restraint rolls set in advance according to the classification such as the size of the steel sheet S. Thus, the processing of Step S2 is completed, and the shape control processing proceeds to the processing of Step S3.

In the processing of Step S3, the shape determination unit 19 calculates the shape prediction result of the steel sheet S on the downstream side of the cooling facility 3 using the shape prediction model M by using the operating condition of the water cooling devices 5 and the operating condition of the restraint devices 6 acquired in the processing of Steps S1 and S2 as the input data. Thus, the processing of Step S3 is completed, and the shape control processing proceeds to the processing of Step S4.

In the processing of Step S4, the shape determination unit 19 compares the shape prediction result calculated in the processing of Step S3 with the allowable range determined in advance according to the steel type, the size, and the like acquired from the host computer 16 or the control computer 10, and determines whether or not the predicted shape is within the allowable range. As the allowable range, when the shape information is defined by the difference between the maximum height and the minimum height in the plane of the steel sheet S, the allowable range is strictly set to 35 mm or less, when the shape information is defined by the standard deviation, the allowable range is strictly set to 25 mm or less, and the standard deviation is strictly set to 15 mm or less, so that a more leveled steel sheet S can be manufactured. However, the allowable range varies depending on the specifications of the steel sheet S to be manufactured.

As a result of the determination, when the predicted shape is within the allowable range (Step S4: Yes), the shape determination unit 19 sends the operating condition of the water cooling devices 5 and the operating condition of the restraint devices 6 acquired in the processing of Steps S1 and S2 to the control computer 10, and a series of shape control processing ends. On the other hand, when the predicted shape is not within the allowable range (Step S4: No), the shape determination unit 19 advances the shape control processing to the processing of Step S5.

In the processing of Step S5, the operating condition resetting unit 19a of the shape determination unit 19 resets the operating condition of the water cooling devices 5 and the operating condition of the restraint devices 6 so that the shape of the steel sheet S falls within the allowable range. Then, the shape determination unit 19 sends the reset operating conditions to the control computer 10. The operating conditions to be reset are desirably at least one of the cooling water amount, the conveyance speed, the upper-lower water amount ratio, the rolling amount of the restraint rolls, and the rolling load. Thus, an appropriate operating condition can be achieved according to the attribute and the manufacturing condition of the steel sheet S. Thus, the series of shape control processing ends.

The shape control processing is not limited to those in which the operating condition is set under a certain condition with respect to the longitudinal direction of the steel sheet S. In the case of generating the shape prediction model M for predicting the shape at several points such as the front end portion, the central portion, and the tail end portion as the shape of the steel sheet S predicted from the shape prediction model M, the operating condition of the water cooling devices 5 may be changed according to the shape of the steel sheet S predicted in the longitudinal direction.

When the shapemeter 4 is installed on the inlet side of the heating furnace 2 or between the heating furnace 2 and the cooling facility 3, information obtained by the shapemeter 4 before heating or before cooling may be added to the input data of the shape prediction model M. Thus, it is possible to consider the effect on the cooling behavior in the cooling facility 3 according to the shape information before heating or before cooling, and the shape prediction accuracy of the steel sheet S is improved.

The steel sheet S subjected to the heat treatment by the heat treatment facility 1 illustrated in FIG. 2 may then be sent to a leveler process or a press straightening process, which is a process of straightening the shape of the steel sheet S after cooling. The process of straightening the shape of the steel sheet S after being subjected to the heat treatment and cooled is referred to as a treatment process. The leveler process is a process of repeatedly applying bending and unbending deformation along the longitudinal direction of the steel sheet S using roller levelers, and is a process of flattening the overall shape of the steel sheet S. On the other hand, the press straightening process is a process of straightening a part in the plane of the steel sheet S in response to the strain generated only in the front end portion and the tail end portion of the steel sheet S, only in the width-direction end portion, and only in a part in the plane. Accordingly, using the shape information of the steel sheet S predicted by the shape prediction model M, it is possible to determine whether to perform sending to either the leveler process or the press straightening process or not to perform sending to any shape straightening process as the process next to the heat treatment process. By predicting the shape information of the steel sheet S using the shape prediction model M in this manner, an appropriate treatment process is selected, and a steel sheet having favorable flatness can be manufactured. In addition, it is also possible to shorten downtime in the manufacturing process of the steel sheet S and improve production efficiency.

Note that the present embodiment has been described for an offline type heat treatment facility, but it goes without saying that the present embodiment can be applied to an online type heat treatment facility. In this case, since the temperature of the steel sheet S at the inlet of the cooling facility 3 changes in the longitudinal direction, the shape prediction model M preferably predicts the shape at a plurality of positions in the longitudinal direction of the steel sheet S. Thus, the shape of the steel sheet S along the longitudinal direction of the steel sheet S conveyed in the cooling facility 3 can be favorable, and the steel sheet S having a small shape change in the longitudinal direction can be manufactured.

### [First Example]

In the present example, in the heat treatment facility 1 illustrated in FIG. 1, the steel sheet S in a room temperature state from which the scale has been removed in advance by shot blasting was heated to 920°C in a nitrogen atmosphere in the heating furnace 2, and then cooled in the cooling facility 3 located at a position L0 (= 2.0 m) away from the heating furnace 2 to manufacture a heat treated steel. The cooling facility 3 is disposed on the downstream side of the heating furnace 2, and seven pairs of water cooling nozzles 51a and 51b and eight pairs of restraint rolls 61a and 61b constituting the water cooling devices 5 were disposed therein. Each water cooling nozzle 51a and each restraint roll 61a can be raised and lowered independently. Flat spray nozzles were used as the water cooling nozzles 51a and 51b. In addition, the shapemeter 4 was installed at a position 5.0 m away downstream from the exit of the cooling facility 3, and the shape of the steel sheet S after passing through the cooling facility was measured.

First, an experiment in a case where only the operation parameter of the water cooling devices 5 was adjusted was performed. The relationship between the shape of the steel sheet S and the manufacturing condition in the case where steel sheets S having sheet thicknesses of 6 mm and 12 mm were cooled to room temperature was confirmed in advance. In the present example, the conveyance speed of the table rolls 7 and the sum of the cooling water amounts from the water cooling nozzles 51a and 51b paired in each cooling zone with an identification number assigned to each cooling zone were used as the operation parameter of the water cooling devices 5, which is the input data of the shape prediction model M. The five pairs of restraint rolls from the most inlet side were used to restrain the steel sheet S, and thereafter, the restraint rolls were raised to the facility upper limit in order to reduce the risk of facility breakage. On the other hand, as the shape information, which is the output data of the shape prediction model M, the difference between the maximum height and the minimum height in the plane of the steel sheet S measured on the basis of the height data of the steel sheet S measured by the shapemeter 4 was used.

At this time, the control computer 10 performed initial setting of the cooling water amount for each water cooling zone of the water cooling devices 5 and the cooling zone for ejecting the cooling water W such that the steel sheet S heated to 920°C in the heating furnace 2 under the nitrogen atmosphere was cooled to room temperature (50°C or lower). Then, the shape at each longitudinal position of the steel sheet S was measured by the shapemeter 4, and the in-plane height distribution of the steel sheet S was measured. Of the in-plane heights measured over the entire surface of the steel sheet S, the value obtained by subtracting the minimum value from the maximum value was evaluated as a shape output value of the steel sheet S, and the condition where the shape output value was 15 mm or less was plotted on the graph as pass "o", and the condition where the shape output value exceeded 15 mm was plotted as fail "x".

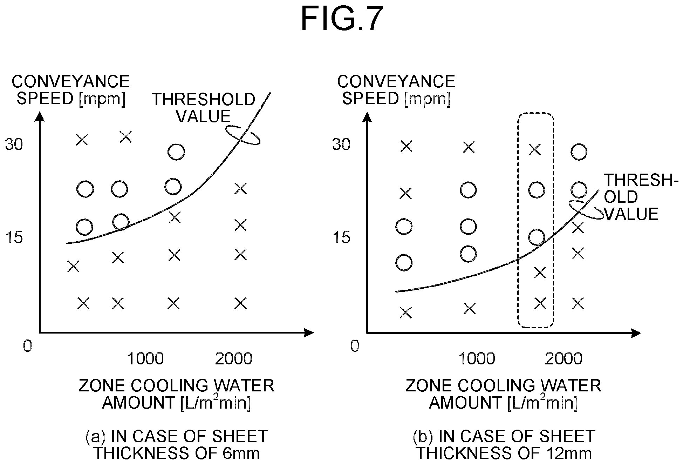

FIG. 7 is a diagram in which pass/fail of a shape of the steel sheet S obtained by preliminary confirmation is organized by conveyance speed and cooling water amount. As illustrated in FIG. 7, it can be seen that in both cases of the sheet thickness of 6 mm and the sheet thickness of 12 mm, as the cooling water amount increases, the conveyance speed required for the shape to pass increases. This is considered to be the effect that as the cooling water amount increases, the cooling rate of the steel sheet S increases, the gradient of the heat shrinkage amount in the longitudinal direction of the steel sheet S increases, and the steel sheet S is easily buckled. In addition, since the gradient of the heat shrinkage amount in the longitudinal direction of the steel sheet S decreases as the conveyance speed increases, it is considered that the shape becomes favorable as the conveyance speed increases even with the same cooling water amount. In addition, it can be seen that the conveyance speed at which the shape passes even with the same cooling water amount is lower when the sheet thickness is 12 mm than when the sheet thickness is 6 mm. This is considered to be because the thicker the steel sheet S, the larger the second moment of area, and the steel sheet S is less likely to be deformed. From the above, it was confirmed that there is a correlation between the operation parameter of the water cooling devices 5 and the shape information of the steel sheet S after passing through the cooling facility 3.

Referring again to FIG. 7, the fail condition occurs again in the upper left part of the graph, that is, in the case of a low cooling water amount and a high conveyance speed. This is considered to be because the martensite transformation region of the steel sheet S moved to the downstream side where restraint by the restraint rolls is absent due to the slow cooling rate and the fast conveyance speed, and the out-of-plane deformation of the steel sheet S could not be suppressed with the initial setting of the restraint rolls. In addition, since it takes a longer time to cool the steel sheet S when the steel sheet S is thicker, it is considered that the fail region in the upper left part of the graph is wider when the sheet thickness is 12 mm. The presence or absence of restraint by each restraint roll constituting the restraint devices 6 is an operation parameter of the restraint devices 6, and it is inferred that there is a correlation between the operation parameter of the restraint devices 6 and the shape information of the steel sheet S after passing through the cooling facility 3.

Next, for the case where the sheet thickness was 12 mm, the relationship between the manufacturing condition and the shape was confirmed regarding the condition surrounded by the dotted line in FIG. 7(b). At the time of cooling the steel sheet S, the steel sheet S was heated to 920°C in the heating furnace 2 under the nitrogen atmosphere, and then the setting of the number of cooling zones for ejection of the cooling water W so that the steel sheet S was cooled to room temperature was appropriately changed, and the setting of the number of roll pairs used for restraint by the restraint devices 6 was appropriately changed to perform heat treatment of the steel sheet S. Since the cooling water amount in the cooling zone of the water cooling devices 5 is substantially constant under the condition surrounded by the dotted line in FIG. 7(b), the number of cooling zones for ejection of the cooling water W and the conveyance speed of the steel sheet were selected as the operation parameter of the water cooling devices 5, and the number of roll pairs used for restraint of the steel sheet S was selected as the operation parameter of the restraint devices 6 to acquire training data. Then, the shape prediction model M using a neural network was created using these operation parameters as the input data and the shape information as the output data. Note that, as the shape information, a value obtained by subtracting the minimum value from the maximum value of the in-plane height measured over the entire surface of the steel sheet S was used.

As a result of predicting the shape of the steel sheet after passing through the cooling facility with respect to various input values using the generated shape prediction model, it was predicted that the conveyance speed needed to be set to 12 mpm or more in order to set the shape output value after cooling to 15 mm or less. In addition, in the dotted line portion in FIG. 7(b), when the conveyance speed was less than 12 mpm, the shape was predicted to be fail, and the specific shape output value was predicted to be 20 to 32 mm. Note that, when the conveyance speed was 12 mpm, the shape was predicted to be pass, and the specific shape output value was 3 to 11 mm. Further, the number of restraint rolls used for restraint of the steel sheet S was reset so that the shape of the steel sheet S after passing through the cooling facility predicted using the shape prediction model was 15 mm or less set as an allowable range, and the heat treatment of the steel sheet S was performed. As a result, even when the steel sheet speed was increased to 30 mpm, a favorable shape could be obtained, which contributed to the expansion of productivity by the expansion of the proper operation range and the improvement of the conveyance speed.

### [Second Example]

In the present example, the steel sheet shape prediction method according to the present embodiment was applied to an offline type heat treatment facility, and the operation parameters of the water cooling devices 5 and the restraint devices 6 were reset so that the predicted shape of the steel sheet fell within a preset allowable range so as to manufacture the steel sheet. The heat treatment facility including the steel sheet cooling facility used in the present example is a facility including seven cooling zones as illustrated in FIG. 1. The steel sheet to be subjected to the heat treatment was directed to those in which manufacturing specifications were set to have a sheet thickness of 6 mm, a sheet width of 2500 mm, a length of 8 m, a heating temperature of 920°C, a target cooling stop temperature of 200°C, and a target cooling rate set to be in a range of 10 to 40°C/s in the surface layer of the steel sheet.

The shape prediction model M of the steel sheet used in the present example acquired, as the output record data, the operation record data of the water cooling devices 5, the operation record data of the restraint devices 6, and the shape information of the steel sheet after passing through the cooling facility 3 for the steel sheet having a sheet thickness of 6 mm of the same steel type (the control range of the component composition of the steel sheet was common) manufactured in the above offline type heat treatment facility. The acquired record data was accumulated in the database unit 18a of the shape prediction model generation unit 18 as a dataset associated with the serial number of the steel sheet. In the present example, as the operation parameter of the water cooling devices 5, the conveyance speed of the steel sheet in the cooling facility 3, the total water amount of the cooling water amounts ejected in the water cooling zone, and the flow rate ratio of the upper and lower water cooling nozzles were used. In addition, the restraint devices 6 set the rolling force of all the restraint rolls to the same value, and selected the rolling force of the restraint rolls as the operation parameter of the restraint devices 6. As the shape information of the steel sheet after passing through the cooling facility 3, the maximum height in the plane of the steel sheet specified on the basis of the height data of the steel sheet measured by the shapemeter 4 was used.

Then, when the number of datasets accumulated in the database unit 18a reached 100, the shape prediction model M was generated by the machine learning unit 18b. A neural network was used as an algorithm of machine learning, and the number of intermediate layers of the neural network was three, and the number of nodes was five. A sigmoid function was used as an activation function. The machine learning unit 18b generated the shape prediction model M using 80 datasets accumulated in the database unit 18a as training data, and verified the accuracy of the shape prediction model M generated using the remaining 20 datasets as test data. As a result, the prediction accuracy of the maximum height of the steel sheet by the generated shape prediction model M was 1.5 mm in standard deviation.

On the other hand, in the control computer 10 of the above offline type heat treatment facility, the operating conditions of the water cooling devices 5 and the restraint devices 6 were set in advance. Specifically, as indicated in a first setting example in Table 1 below, the conveyance speed of the steel sheet in the cooling facility 3 was 40 m/min, the total water amount of the cooling water amounts ejected in the water cooling zone was 2300 L/m²min, the flow rate ratio of the upper and lower water cooling nozzles was 1.5, and the rolling force of the restraint rolls was 20 kN. The flow rate ratio of the water cooling nozzles (upper-lower water amount ratio) is a ratio of the cooling water amount ejected from the upper water cooling nozzle to the cooling water amount ejected from the lower water cooling nozzle. However, when the steel sheet was subjected to the heat treatment under the operating condition of the first setting example, the maximum height in the plane of the steel sheet was 40 mm, which was significantly out of the allowable range of the shape (the maximum height was 15 mm or less for the steel sheet used in the present example). Therefore, the operation was performed under the condition of a second setting example in which the setting value of the rolling force of the restraint rolls was changed to 80 kN in order to suppress strain during cooling of the steel sheet. As a result, the maximum height in the plane of the steel sheet was 17 mm, which was improved as compared with the condition of the first setting example, but the allowable range of the shape could not be satisfied.

On the other hand, in the present example, the shape prediction model M generated by the shape prediction model generation unit 18 was loaded into the shape determination unit 19 illustrated in FIG. 5, and the operating condition of the second setting example was set as the initial value by the control computer 10. Then, before cooling the steel sheet in the cooling facility 3, the shape determination unit 19 predicted the shape of the steel sheet S on the exit side of the cooling facility 3, and reset the operation parameter of the water cooling devices 5 with the operating condition resetting unit 19a so that the predicted shape of the steel sheet fell within the preset allowable range. In the first example indicated in Table 1, as the operation parameter of the water cooling devices 5 to be reset, the conveyance speed of the steel sheet in the cooling facility 3, the total water amount of the cooling water amounts ejected in the water cooling zone were selected. On the other hand, in the second example indicated in Table 1, as the operation parameter of the water cooling devices 5 to be reset, the flow rate ratio of the upper and lower water cooling nozzles was selected.

Table 1 indicates the maximum heights of the steel sheets according to the first example and the second example. As indicated in Table 1, according to the first example and the second example, it was confirmed that the maximum heights of the steel sheets both satisfy the allowable range of the shape by resetting the operating condition of the water cooling devices 5 with the operating condition resetting unit 19a.

**Table 1**

| | Operation parameter of water cooling device | | | Operation parameter of restraint device | Maximum height of steel sheet |
|---|---|---|---|---|---|
| | Conveyance speed m/min | Water amount L/m²min | Upper-lower water amount ratio | Rolling force kN | Shape output value mm |
| First example | 30 | 1800 | 1.5 | 80 | 10 |
| Second example | 40 | 2300 | 1.65 | 80 | 14 |
| First setting example | 40 | 2300 | 1.5 | 20 | 40 |
| Second setting example | 40 | 2300 | 1.5 | 80 | 17 |

### [Third Example]

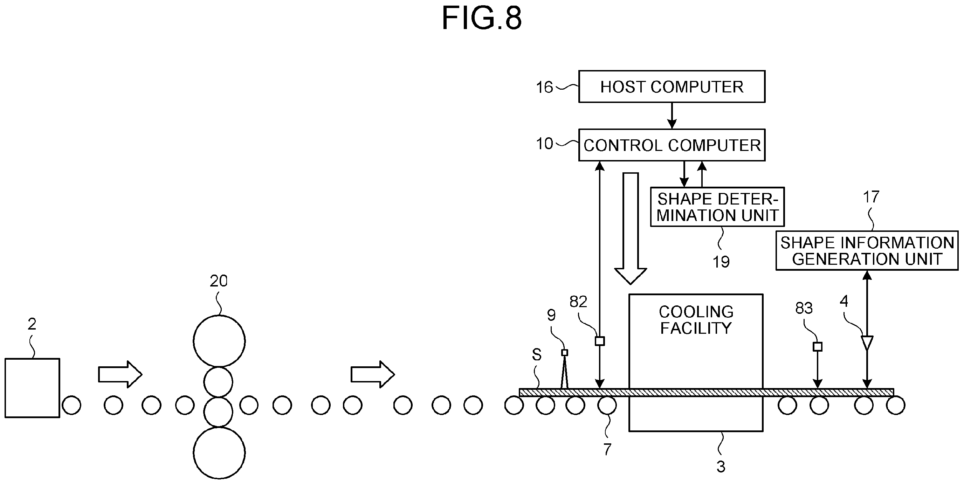

In the present example, the steel sheet shape prediction method according to the present embodiment was applied to an online type heat treatment facility, and direct quenching was executed on a plurality of steel sheets of the same steel type (the control range of the component composition of the steel sheet was common). As illustrated in FIG. 8, the cooling facility used in the present example was disposed on the hot rolling line. The hot rolling line illustrated in FIG. 8 includes the heating furnace 2, a rolling mill 20, and the cooling facility 3. In the heating furnace 2, a slab after casting is heated to a predetermined temperature. The rolling mill 20 is a reverse type rolling mill, and is a facility for performing multi-pass rolling on a steel sheet to have a predetermined sheet thickness and sheet width. The steel sheet rolled into a predetermined dimension by the rolling mill 20 is in a state of being heated to a high temperature state, and then subjected to a heat treatment process using the cooling facility 3. In addition, an inlet-side thermometer 82 for measuring the temperature of the steel sheet is installed at a position 3 m away from the inlet of the cooling facility 3 on the upstream side of the cooling facility 3. Temperature data of the steel sheet measured by the inlet-side thermometer 82 is sent to the control computer 10. Note that a descaling device 9 is disposed on the upstream side of the inlet-side thermometer 82, and the descaling device 9 removes an oxide scale generated on the surface of the steel sheet. Thus, it is possible to reduce a measurement error of temperature data measured by the inlet-side thermometer 82. As the cooling facility 3 disposed in the online type heat treatment facility, those similar to that illustrated in FIG. 1 can be used. That is, the cooling facility 3 includes the water cooling devices 5 and the restraint devices 6 for water cooling of the steel sheet under a predetermined cooling condition. However, in the online type heat treatment facility, when the steel sheet that has been rolled by the rolling mill 20 passes through the cooling facility 3 at a predetermined conveyance speed, the steel sheet temperature changes in the longitudinal direction on the inlet side of the cooling facility 3. In this respect, it is different from the offline type heat treatment facility.

In the present example, as in the above example, the conveyance speed of the steel sheet in the cooling facility 3, the total water amount of the cooling water amounts ejected in the water cooling zone, the flow rate ratio of the upper and lower water cooling nozzles, and the rolling force of the restraint rolls were selected as inputs of the shape prediction model M of the steel sheet. In the present example, in addition to these, the temperature information measured by the inlet-side thermometer 82, which is an operation parameter of the water cooling devices 5, was selected. The temperature information of the steel sheet measured by the inlet-side thermometer 82 is information corresponding to the cooling start temperature, which is a temperature when cooling of the steel sheet is started. In addition, in the present example, in the online type heat treatment facility illustrated in FIG. 8, a cast slab (sheet thickness of 260 mm, sheet width of 1900 mm) was heated to 1150°C in the heating furnace 2, and then formed into a steel sheet having a sheet thickness of 6 mm, a sheet width of 2800 mm, and a length of about 80 m by the rolling mill 20. Then, the steel sheet was subjected to heat treatment by causing the steel sheet to pass through the cooling facility 3, and shape information of the steel sheet was acquired with the shapemeter disposed on the exit side of the cooling facility. In the online type heat treatment facility, since the shape often changes in the longitudinal direction of the steel sheet, the position of the steel sheet was specified at a pitch of 10 m along the longitudinal direction of the steel sheet from the front end portion of the steel sheet, and shape information corresponding to each position was acquired. In this case, the shape information of the steel sheet is the maximum height in the sheet width direction acquired at a predetermined position along the longitudinal direction of the steel sheet.

Similarly, for the operation record data of the water cooling devices 5 and the operation record data of the restraint devices 6, the position was specified at a pitch of 10 m from the front end portion of the steel sheet, and the operation record data corresponding to each position was acquired. Specifically, the cooling start temperature of the steel sheet was measured with the inlet-side thermometer 82 of the cooling facility 3 at a pitch of 10 m. In addition, the setting values of the conveyance speed of the steel sheet in the cooling facility 3, the total water amount of the cooling water amounts ejected in the water cooling zone, the flow rate ratio of the upper and lower water cooling nozzles, and the record value of the rolling force of the restraint rolls were also acquired at a pitch of 10 m along the longitudinal direction of the steel sheet. Note that these pieces of operation record data were acquired in synchronization with the timing of acquiring the temperature information with the inlet-side thermometer 82. The acquired operation record data is accumulated in the database unit 18a in association with the shape information of the steel sheet at the corresponding position. That is, for one steel sheet, a plurality of datasets corresponding to the longitudinal position of the steel sheet was accumulated.

In the present example, when datasets for 50 steel sheets were accumulated in the database unit 18a, the shape prediction model M was generated by the machine learning unit 18b. A neural network was used as an algorithm of machine learning, and the number of intermediate layers of the neural network was three, and the number of nodes was five. A sigmoid function was used as an activation function. The machine learning unit 18b generated the shape prediction model M using datasets acquired from 35 steel sheets accumulated in the database unit 18a as training data, and verified the accuracy of the shape prediction model M generated using datasets acquired from the remaining 15 steel sheets as test data. As a result, the prediction accuracy of the maximum height of the steel sheet by the generated shape prediction model M was 2.5 mm in standard deviation.

On the other hand, in the control computer 10 of the above online type heat treatment facility, the operating conditions of the water cooling devices 5 and the restraint devices 6 were set in advance. Specifically, the conveyance speed of the steel sheet in the cooling facility 3 was 20 m/min, the total water amount of the cooling water amounts ejected in the water cooling zone was 2300 L/m²min, the flow rate ratio of the upper and lower water cooling nozzles was 1.5, and the rolling force of the restraint rolls was 80 kN. However, for these setting values, constant values were set regardless of the cooling start temperature of the steel sheet (third setting example). However, when the steel sheet was subjected to the heat treatment under the operating condition of the third setting example, the maximum height in the plane of the steel sheet was 29 mm, which was significantly out of the allowable range of the shape (the maximum height was 15 mm or less for the steel sheet used in the present example). In particular, the shape of the tail end portion of the steel sheet was deteriorated.

On the other hand, in the present example, the shape prediction model M generated by the shape prediction model generation unit 18 was loaded into the shape determination unit 19 illustrated in FIG. 5, and the operating condition of the third setting example was set to the initial setting by the control computer 10. Then, the shape determination unit 19 measured the cooling start temperature of the steel sheet at a pitch of 10 m along the longitudinal direction from the stage where the front end portion of the steel sheet reached the inlet-side thermometer 82 of the cooling facility 3. The measured temperature data was input into the shape prediction model M of the shape determination unit 19 together with the operation data of the conveyance speed of the steel sheet in the cooling facility 3, the total water amount of the cooling water amounts ejected in the water cooling zone, the flow rate ratio of the upper and lower water cooling nozzles, and the rolling force of the restraint rolls, and the shape information of the steel sheet was predicted. Thus, when the portion reached the inlet-side thermometer 82 at a pitch of 10 m along the longitudinal direction of the steel sheet, the shape of the steel sheet on the exit side of the cooling facility 3 was predicted as needed, and therefore, the operating condition resetting unit 19a reset the operation parameter of the water cooling devices 5 as needed so that the predicted shape fell within the allowable range. The operation parameter of the water cooling devices 5 reset in the present example is the total water amount of cooling water amounts ejected in the water cooling zone. As a result, it was confirmed that the maximum height in the plane of the steel sheet was reduced to 8 mm, and the allowable range of the shape was satisfied.

Although the embodiments to which the invention made by the present inventors is applied have been described above, the present invention is not limited by the description and drawings constituting a part of the disclosure of the present invention according to the present embodiments. That is, other embodiments, examples, operation techniques, and the like made by those skilled in the art on the basis of the present embodiments are all included in the scope of the present invention.

### Industrial Applicability

According to the present invention, it is possible to provide a steel sheet shape prediction method capable of accurately predicting the shape information of the steel sheet after passing through the cooling facility. In addition, according to the present invention, it is possible to provide a steel sheet shape control method capable of accurately controlling the shape of the steel sheet after passing through the cooling facility within an allowable range. In addition, according to the present invention, it is possible to provide a steel sheet shape prediction model generation method for generating a shape prediction model capable of accurately predicting shape information of the steel sheet after passing through the cooling facility. In addition, according to the present invention, it is possible to provide a steel sheet manufacturing method and manufacturing facility capable of manufacturing a steel sheet having favorable flatness.

### Reference Signs List

- 1: HEAT TREATMENT FACILITY
- 2: HEATING FURNACE
- 3: COOLING FACILITY
- 4: SHAPEMETER
- 5: WATER COOLING DEVICE
- 6: RESTRAINT DEVICE
- 7: TABLE ROLL
- 10: CONTROL COMPUTER
- 10a: WATER-COOLING CONDITION CALCULATION UNIT
- 10b: RESTRAINT CONDITION SETTING UNIT
- 11: WATER-COOLING FLOW RATE CONTROL DEVICE
- 12: RESTRAINT ROLL CONTROL DEVICE
- 13: ROLLING CONTROL DEVICE
- 14: ROLLING POSITION MEASURING INSTRUMENT
- 15: DRAINAGE PURGE NOZZLE
- 15a: DRAINAGE PURGE
- 16: HOST COMPUTER
- 17: SHAPE INFORMATION GENERATION UNIT
- 18: SHAPE PREDICTION MODEL GENERATION UNIT
- 18a: DATABASE UNIT
- 18b: MACHINE LEARNING UNIT
- 19: SHAPE DETERMINATION UNIT
- 19a: OPERATING CONDITION RESETTING UNIT
- 20: ROLLING MILL
- 51a, 51b: WATER COOLING NOZZLE
- 61a, 61b: RESTRAINT ROLL
- 81, 82, 83: THERMOMETER
- M: SHAPE PREDICTION MODEL
- S: STEEL SHEET
- W: COOLING WATER

## Claims

1. A steel sheet shape prediction method in a cooling facility for a steel sheet, the cooling facility including a water cooling device that cools a steel sheet by ejecting cooling water to a heated steel sheet, and a restraint device that restrains the steel sheet being cooled with at least a pair of restraint rolls, the method comprising:
predicting shape information of the steel sheet after passing through the cooling facility by using
a shape prediction model generated by machine learning using at least one operation parameter selected from each of an operation parameter of the water cooling device and an operation parameter of the restraint device as input data and
shape information of the steel sheet after passing through the cooling facility as output data.

2. The steel sheet shape prediction method according to claim 1, wherein the shape prediction model includes an attribute information parameter selected from attribute information of the steel sheet as the input data.

3. The steel sheet shape prediction method according to claim 1 or 2, wherein the operation parameter of the water cooling device includes at least one of a cooling water amount, an upper-lower water amount ratio of cooling water, a cooling rate of the steel sheet, and a conveyance speed of the steel sheet in a cooling facility.

4. The steel sheet shape prediction method according to any one of claims 1 to 3, wherein the operation parameter of the restraint device includes at least one of a rolling position and a rolling force of the restraint roll.

5. A steel sheet shape control method comprising:
predicting a shape of the steel sheet after passing through the cooling facility using the steel sheet shape prediction method according to any one of claims 1 to 4; and resetting at least one operation parameter selected from the operation parameters of the water cooling device and the restraint device so that the predicted shape falls within a preset allowable range.

6. A steel sheet manufacturing method, comprising:
manufacturing a steel sheet using the steel sheet shape control method according to claim 5.

7. A steel sheet manufacturing method, comprising:
predicting a shape of a steel sheet after passing through the cooling facility using the steel sheet shape prediction method according to any one of claims 1 to 4; and
determining a treatment process of the steel sheet on a basis of the predicted shape.

8. A steel sheet shape prediction model generation method in a cooling facility for a steel sheet, the cooling facility including a water cooling device that cools a steel sheet by ejecting cooling water to a heated steel sheet, and a restraint device that restrains the steel sheet being cooled with at least a pair of restraint rolls, the method comprising:
generating a shape prediction model of a steel sheet after passing through the cooling facility by machine learning using a plurality of pieces of training data in which information including
at least one piece of operation record data selected from each of operation record data of the water cooling device and operation record data of the restraint device is used as input record data and
shape information of the steel sheet after passing through the cooling facility corresponding to the input record data is used as output record data.

9. The steel sheet shape prediction model generation method according to claim 8, wherein machine learning selected from a neural network, decision tree learning, random forest, and support vector regression is used as the machine learning.

10. A steel sheet manufacturing facility comprising:
a cooling facility including
a water cooling device that cools a steel sheet by ejecting cooling water to a heated steel sheet, and
a restraint device that restrains the steel sheet being cooled with at least a pair of restraint rolls; and
a shape prediction unit that outputs shape information of a steel sheet after passing through the cooling facility,
wherein the shape prediction unit is a machine-learned model using
at least one operation parameter selected from each of an operation parameter of the water cooling device and an operation parameter of the restraint device as input data and
shape information of the steel sheet after passing through the cooling facility as output data.
